# EUROPEAN PATENT SPECIFICATION

(11) **EP 1 751 858 B1**
(45) Date of publication and mention of the grant of the patent: **14.01.2009**
(21) Application number: 05737419.1
(22) Date of filing: 13.04.2005
(51) Int. Cl.: H03H 3/04, H03H 9/205, H01L 41/08

(54) **Forming integrated film bulk acoustic resonators having different frequencies**
Herstellung integrierter, akustischer Dünnschichtresonatoren (FBAR) mit unterschiedlichen Frequenzen
Fabrication de résonateurs acoustiques intégrés à couches minces (FBAR) ayant des fréquences différentes

(30) Priority: 07.05.2004 US 841402
(43) Date of publication of application: 14.02.2007
(73) Proprietor: Intel Corporation, Santa Clara, CA 95052 (US)
(72) Inventor: MA, Qing, San Jose, CA 95129 (US); WANG, Li-Peng, Santa Clara, CA 95051 (US); SHIM, Dong, Framingham, MA 01701 (US); RAO, Valluri, Saratoga, CA 95070 (US)
(74) Representative: Dunlop, Hugh Christopher
(86) International application number: PCT/US2005/012910
(87) International publication number: WO 2005/114836

(56) References cited:
- EP-A- 1 225 695
- DE-A1- 10 241 425
- US-A1- 2002 121 944
- US-A1- 2004 017 130
- US-B1- 6 657 363
- PATENT ABSTRACTS OF JAPAN vol. 006, no. 037 (E-097), 6 March 1982 (1982-03-06) -& JP 56 154813 A (MURATA MFG CO LTD), 30 November 1981 (1981-11-30)

## Description

### Background

This invention relates generally to front-end radio frequency filters, including film bulk acoustic resonators (FBAR).

Film bulk acoustic resonators have many advantages compared to other techniques such as surface acoustic wave (SAW) devices and ceramic filters, particularly at high frequencies. For example, SAW filters begin to have excessive insertion losses above 2.4 gigaHertz and ceramic filters are much larger in size and become increasingly difficult to fabricate at higher frequencies.

A conventional FBAR filter may include two sets of FBARs to achieve the desired filter response. The series FBARs may have one frequency and the shunt FBARs may have another frequency. Thus, for a variety of reasons, it is desirable to have filters of two or more frequency bands (termed plural frequency FBARs herein) on the same integrated circuit. A typical single band radio frequency (RF) filter has two sets of resonators, series, and shunt, with two different frequencies. In a typical cell phone, several filters for different bands are used. It is highly desirable to integrate several filters on the same silicon wafer. For example, two filters on the same silicon will need four sets of resonators with four different frequencies.

However, achieving integrated frequency FBARs is challenging using existing fabrication techniques. Those techniques are insufficiently controllable to achieve multiple thickness targets needed for reproducibly manufacturing integrated circuits with frequencies of more than one band.

Thus, although US 6,657,363 B1 discloses tuning FBARs by patterning either the upper electrode or an additional layer thereon with features sizes of the resulting pattern smaller than the acoustic wavelength there is a need for better ways to make integrated circuit FBARs having more than one frequency band, which is met by the invention as defined in the appended claim.

### Brief Description of the Drawings

Figure 1 is an enlarged, cross-sectional view of one embodiment of the present invention at an early stage of manufacture;
Figure 2 is an enlarged, cross-sectional view of the embodiment shown in Figure 1 at a subsequent stage of manufacture;
Figure 3 is an enlarged, cross-sectional view of the embodiment shown in Figure 2 at a subsequent stage of manufacture;
Figure 4 is an enlarged, top plan view of the embodiment shown in Figure 3 in accordance with one embodiment of the present invention;
Figure 5 is an enlarged, cross-sectional view of a related example not covered by the present invention prior to completion;
   and
Figure 6 is an enlarged, cross-sectional view of the related example shown in Figure 5 after completion.

### Detailed Description

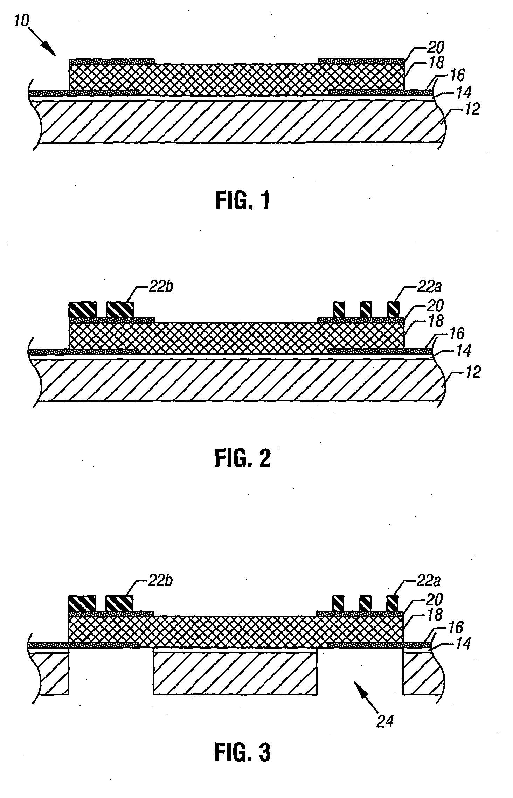

Referring to Figure 1, a film bulk acoustic resonator (FBAR) 10 may include an upper electrode 20 and a bottom electrode 16 sandwiching a piezoelectric layer 18. That structure may be formed over a dielectric layer 14 formed on a substrate 12. In accordance with one embodiment of the present invention, the dielectric layer 14 may be formed of silicon dioxide. The bottom electrode 16 may be formed of material such as aluminum, molybdenum, platinum, or tungsten, for example.

The piezoelectric layer 18 may be formed of aluminum nitride, lead zirconium titanate (PZT), or zinc oxide, to mention a few examples. The upper electrode 20 may be formed of the same materials as the bottom electrode 16.

While a bulk micromachined fabrication technique is set forth below, the present invention is equally applicable to surface micromachined FBAR processes as well.

The structure shown in Figure 1 is covered with a layer of a modulating material. The modulating material is a material that has a high acoustic quality factor such as aluminum oxide, polysilicon, molybdenum, or tungsten.

The deposited layer of modulating material is then patterned to form the structure shown in Figure 2. The patterning forms a series of stripes including stripes 22a of one width (horizontal) and stripes 22b of another width. The pattern of stripes 22a, 22b is chosen to determine the frequency of the resulting FBAR.

Finally, referring to Figure 3, a backside silicon etch may be utilized to form the trenches 24 and resulting membranes over the trenches 24.

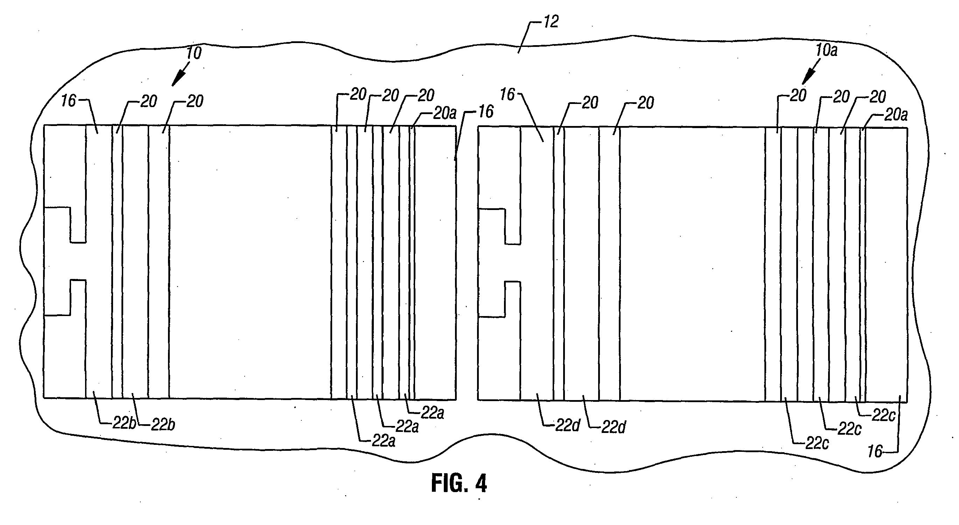

As shown in Figure 4, a first FBAR 10 may have a bottom electrode 16 that forms contact surfaces for making electrical connections to the FBAR 10. The stripes 22b extend completely across the FBAR, as do the stripes 22a. However, the spacing between the stripes 22a may be different, as well as their widths, in one embodiment.

The stripes 22a, 22b may be formed using conventional lithographic techniques involving patterning and etching. Thus, extremely tight control may be had over the precise nature of the modulating material.

A second FBAR 10a may be formed on the same substrate 12. It may operate over a different frequency because its stripes 20c and 20d are dimensionally different from the stripes 20a and 20b of the FBAR 10.

Lithographically patterned features, such as those shown in Figure 3, on top of FBAR membranes create resonance modes with frequencies governed by the dimension and shape of those features. Thus, resonators of various frequencies may be produced using membranes of the same thickness. In other words, on the same integrated circuit, FBARs with different frequencies, called plural frequency FBARs, can be produced using conventional integrated circuit fabrication techniques which are highly reproducible, in some embodiments of the present invention.

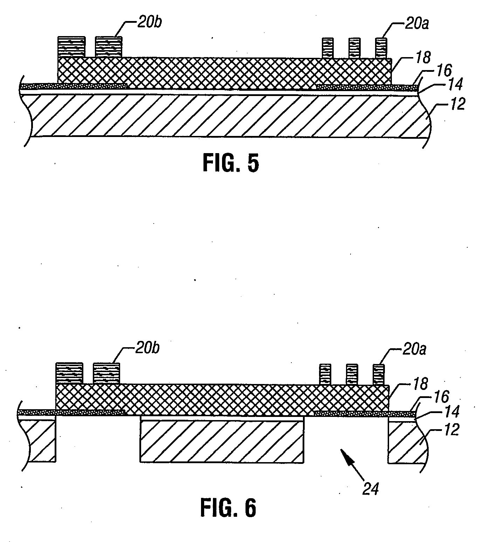

Referring to Figure 5, in a related example not covered by the present invention, the upper electrode 20 may be dispensed with and may be formed as a series of stripes 20a and 20b of modulating material. In other words, the modulating material not only sets the frequency of the FBAR, but also provides its upper electrode 20. A layer 20 of material, which may be made of any of the material useful in forming electrodes in FBARs, may have its (vertical) thickness adjusted to provide the desired frequency. Thus, the pattern and shape of the stripes 20a and 20b may be varied to achieve the desired frequency performance. The spacing, size, and/or thickness in the vertical direction of the stripes 20 may be varied to achieve the desired performance in the related example.

Referring to Figure 6, a cavity 24 may be defined through the substrate 12 to create the FBAR membrane structure.

Also, FBARs of any number of different frequencies may be formed on the same integrated circuit.

While the present invention has been described with respect to a limited number of embodiments, those skilled in the art will appreciate numerous modifications and variations therefrom. It is intended that the appended claim covers all such modifications and variations as fall within its scope.

## Claims

1. A method of forming, on the same integrated circuit, film bulk acoustic resonators with different frequencies comprising:
forming a first film bulk acoustic resonator (10) on an integrated circuit, said first film bulk acoustic resonator having a first frequency;
forming a second film bulk acoustic resonator (10a) on said integrated circuit at a second frequency, different from said first frequency; forming a bottom electrode (16) over a substrate (12), a piezoelectric material (18) over said bottom electrode, and an upper electrode (20) over said piezoelectric material for each resonator (10, 10a) and using lithography and patterning to distinguish said resonators; **characterised in**
forming stripes of modulating material (22a-22d) of different widths over the upper electrodes (20) to set the frequency band of each of said two film bulk acoustic resonators, and said stripes extending completely across the respective film bulk acoustic resonators.

## Patentansprüche

1. Verfahren zum Herstellen von Film-Bulk-Acoustic-Resonatoren (FBAR) mit unterschiedlichen Frequenzen, auf derselben integrierten Schaltung, umfassend:
Herstellen eines ersten Film-Bulk-Acoustic-Resonators (10) auf einer integrierten Schaltung, wobei der erste Film-Bulk-Acoustic-Resonator eine erste Frequenz hat;
Herstellen eines zweiten Film-Bulk-Acoustic-Resonators (10a) auf der integrierten Schaltung, der eine zweite Frequenz hat, die sich von der ersten Frequenz unterscheidet;
Herstellen einer unteren Elektrode (16) über einem Substrat (12), eines piezoelektrischen Materials (18) über der unteren Elektrode, und einer oberen Elektrode (20) über dem piezoelektrischen Material für jeden Resonator (10, 10a), und
Verwenden von Lithographie und Musterung zum Differenzieren der Resonatoren; **gekennzeichnet durch**
Herstellen von Streifen von Modulationsmaterial (22a-22d) mit unterschiedlichen Breiten über den oberen Elektroden (20), um das Frequenzband jedes der beiden Film-Bulk-Acoustic-Resonatoren einzustellen, und wobei die Streifen sich vollständig über die zugehörigen Film-Bulk-Acoustic-Resonatoren erstrecken.

## Revendications

1. Procédé de formation, sur le même circuit intégré, de résonateurs acoustiques à couche mince avec différentes fréquences, comprenant :
la formation d'un premier résonateur acoustique à couche mince (10) sur un circuit intégré, ledit premier résonateur acoustique à couche mince ayant une première fréquence ;
la formation d'un second résonateur acoustique à couche mince (10a) sur ledit circuit intégré à une seconde fréquence, différente de ladite première fréquence ; la formation d'une électrode inférieure (16) sur un substrat (12), un matériau piézoélectrique (18) sur ladite électrode inférieure, et une électrode supérieure (20) sur ledit matériau piézoélectrique pour chaque résonateur (10, 10a) et l'utilisation d'une lithographie et d'une formation de motif pour distinguer lesdits résonateurs ;
**caractérisé en**
la formation de bandes de matériau de modulation (22a-22d) de différentes largeurs sur les électrodes supérieures (20) pour régler la bande de fréquence de chacun desdits deux résonateurs acoustiques à couche mince, et lesdites bandes s'étendant complètement à travers les résonateurs acoustiques à couche mince respectifs.
